# EUROPÄISCHE PATENTANMELDUNG

(11) **EP 3 385 983 A1**
(43) Veröffentlichungstag der Anmeldung: **10.10.2018**
(21) Anmeldenummer: 17164700.1
(22) Anmeldetag: 04.04.2017
(51) Int. Cl.: H01L 23/485, H01L 23/49, H01L 21/60, H01L 21/603, H01L 21/683

(54) **ADAPTERSYSTEM ZUR KONTAKTBEREICHSVERGRÖSSERUNG ZUMINDEST EINER KONTAKTOBERFLÄCHE AUF ZUMINDEST EINEM ELEKTRONIKBAUTEIL UND VERFAHREN ZUR KONTAKTBEREICHSVERGRÖSSERUNG**

(71) Anmelder: Heraeus Deutschland GmbH & Co. KG, 63450 Hanau (DE)
(72) Erfinder: KLEIN, Andreas, 63579 Freigericht (DE); HINRICH, Andreas, 63579 Freigericht (DE); DIETRICH, Peter, 63322 Rödermark (DE)
(74) Vertreter: Heraeus IP

(57) **Zusammenfassung**

Ein Adaptersystem zur Kontaktbereichsvergrößerung zumindest einer Kontaktoberfläche (11, 11a', 11b', 11c', 11d', 11e', 11f', 11") auf zumindest einem Elektronikbauteil (9, 9', 9") (z.B. einem Leistungshalbleiter) weist auf: zumindest ein Substrat (3, 3a', 3b', 3") mit einer ersten Seite und einer der ersten Seite gegenüberliegenden zweiten Seite; und zumindest ein Kontaktierungselement (5, 5a', 5"), das zumindest bereichsweise auf der ersten Seite des Substrats (3, 3a', 3b', 3") angeordnet ist, wobei das Kontaktierungselement (5, 5a', 5") angepasst ist, die erste Seite mit der Kontaktoberfläche (11, 11a', 11b', 11c', 11d', 11e', 11f', 11") des Elektronikbauteils (9, 9', 9") elektrisch zu verbinden, wobei eine Oberfläche der zweiten Seite des Substrats (3, 3a', 3b', 3") größer ist als die Kontaktoberfläche (11, 11a', 11b', 11c', 11d', 11e', 11") des Elektronikbauteils (9, 9', 9"). Das Adaptersystem kann weiter zumindest ein Fixierungselement (7, 7a', 7") aufweisen, das auf der ersten Seite des Substrats (3, 3a', 3b', 3") zumindest bereichsweise um das Kontaktierungselement (5, 5a', 5") herum angeordnet ist, wobei das Fixierungselement (7, 7a', 7") angepasst ist das Elektronikbauteil (9, 9', 9") mechanisch zu kontaktieren, insbesondere die erste Seite des Substrats (3, 3a', 3b', 3") mit dem Elektronikbauteil (9, 9', 9") mechanisch zu verbinden. Die zweite Seite des Substrats (3, 3a', 3b', 3") kann zum Verbinden mit einem Verbindungselement, insbesondere mit einem Bonddraht, angepasst sein. Das Substrat (3, 3a', 3b', 3") kann ein elektrisch leitendes Material aufweisen. Das Kontaktierungselement (5, 5a', 5") kann eine Sinterpaste aufweisen. Es können zumindest zwei Substrate (3a', 3b') zumindest bereichsweise auf dem Elektronikbauteil (9') angeordnet sein und/oder mindestens zwei Kontaktoberflächen (11b', 11c', 11d', 11e', 11f') mit einem einzelnen Kontaktierungselement (5, 5a', 5") elektrisch verbunden sein.

## Beschreibung

Die vorliegende Erfindung betrifft ein Adaptersystem zur Kontaktbereichsvergrößerung zumindest einer Kontaktoberfläche auf zumindest einem Elektronikbauteil. Weiterhin betrifft die vorliegende Erfindung ein Verfahren zur Kontaktbereichsvergrößerung zumindest einer Kontaktoberfläche auf zumindest einem Elektronikbauteil und ein Elektronikbauteil mit einem Adaptersystem.

Im Stand der Technik werden Bonddrähte, bzw. Bondverbindungen häufig bei Leistungshalbleitern verwendet, um die Leistungshalbleiter elektrisch zu kontaktieren. Typischerweise weist der Leistungshalbleiter in dem zu kontaktierenden Bereich eine Kontaktoberfläche, beispielweise einen Last- oder Steueranschluss, meist aus Aluminium oder einer Aluminiumlegierung auf. Die Kontaktierung des Leistungshalbleiters erfolgt dabei mittels einer zwischen der Kontaktoberfläche und dem Bonddraht ausgebildeten Bondverbindung. Es sind auch aus dem Stand der Technik weitere Möglichkeiten zur Kontaktierung von Leistungshableitern bekannt, wie beispielsweise eine Verbindung mit Presskontakten.

Steigende Anforderungen hinsichtlich der Leistung und Lebensdauer von Leistungshalbleitern erhöhen die Anforderungen an die Kontaktierung der Leistungshalbleiter auf der Ober-wie auch an der Unterseite. Um die Kontaktierung zu verbessern schlägt beispielsweise die DE 10 2014 117 245 A1 einen Adapter vor, der auf dem Leistungshalbleiter angeordnet werden kann. In den bekannten Anordnungen des Adapters fließt der Strom vertikal durch den Leistungshalbleiter.

Allerdings ist aus dem Stand der Technik keine zufriedenstellende Lösung bekannt zur Kontaktierung von Leistungshalbleitern mit Kontaktoberflächen, die alle auf einer Seite des Leistungshalbleiters liegen, sogenannten lateralen Leistungshalbleitern. Bei diesen Anordnungen führt eine ständige Erhöhung der Leistungsdichte dazu, dass nicht genügend Fläche zur Kontaktierung zur Verfügung steht.

Aufgabe der vorliegenden Erfindung ist es daher, ein verbessertes System und Verfahren zur Kontaktierung von Leistungshalbleitern mit in ihrer Ausdehnung begrenzten Kontaktoberflächen bereitzustellen.

Diese Aufgabe wird erfindungsgemäß durch ein Adaptersystem gemäß des Gegenstands des Patentanspruchs 1 gelöst.

Das erfindungsgemäße Adaptersystem zur Kontaktbereichsvergrößerung zumindest einer Kontaktoberfläche auf zumindest einem Elektronikbauteil weist hierfür auf:
zumindest ein Substrat mit einer ersten Seite und einer der ersten Seite gegenüberliegenden zweiten Seite; zumindest ein Kontaktierungselement, das zumindest bereichsweise auf der ersten Seite des Substrats angeordnet ist, wobei das Kontaktierungselement angepasst ist die erste Seite mit der Kontaktoberfläche des Elektronikbauteils elektrisch zu verbinden, wobei eine Oberfläche der zweiten Seite des Substrats größer ist als die Kontaktoberfläche des Elektronikbauteils.

In diesem Zusammenhang kann der Begriff "Elektronikbauteil" verwendet werden, um ein elektronisches, beziehungsweise elektrisches Bauelement, zu bezeichnen. Der Begriff "Elektronikbauteil" kann daher Bauelemente umfassen, die in der Leistungselektronik verwendet werden, wie beispielsweise einen Leistungstransistor. In einem Beispiel kann das erfindungsgemäße Adaptersystem mit dem Elektronikbauteil verwendet werden. In einem weiteren Beispiel der Erfindung kann das erfindungsgemäße Adaptersystem das Elektronikbauteil umfassen. Der Begriff "Kontaktoberfläche" kann verwendet werden, um einen Bereich oder mehrere Bereiche an dem Elektronikbauteil zu bezeichnen, mit denen elektrisch leitende Verbindungen hergestellt werden können. Auch der Begriff "Kontaktierungselement" kann dazu verwendet werden, um einen Bereich zu bezeichnen, mit dem eine elektrisch leitende Verbindung hergestellt werden kann.

Erfindungsgemäß ist eine Oberfläche der zweiten Seite des Substrats größer als die Kontaktoberfläche des Elektronikbauteils. Hierfür kann das Substrat zumindest bereichsweise elektrisch leitend sein, so dass eine elektrische Verbindung zwischen dem Substrat und der Kontaktoberfläche des Elektronikbauteils besteht. Auch kann das Substrat Beschichtungen und/oder Anbauteile aufweisen.

Unter der Bezeichnung "größer als die Kontaktoberfläche" kann im Sinne der Erfindung verstanden werden, dass zumindest die zweite Seite des Substrats den gesamten Bereich der Kontaktoberfläche vollständig überdeckt.

Der Erfindung liegt somit die überraschende Erkenntnis zu Grunde, dass Leistungshalbleiter mit in der räumlichen Ausdehnung begrenzten Kontaktoberflächen besser kontaktiert werden können.

Mit der Erfindung ist es erstmalig gelungen die zum Kontaktieren zur Verfügung stehende Fläche an einem Elektronikbauteil deutlich zu vergrößern. Durch diese Kontaktbereichsvergrößerung wird die Stromtragfähigkeit des resultierenden Kontaktbereichs, sowie die Wärmeleitung und Wärmekapazität auf der Kontaktseite des Elektronikbauteils erhöht.

In einem Beispiel weist das Adaptersystem zumindest ein Fixierungselement auf, das auf der ersten Seite des Substrats zumindest bereichsweise um das Kontaktierungselement herum angeordnet ist, wobei das Fixierungselement angepasst ist das Elektronikbauteil mechanisch zu kontaktieren, insbesondere die erste Seite des Substrats mit dem Elektronikbauteil mechanisch zu verbinden.

Hierfür kann das Fixierungselement im Wesentlichen die gleiche Höhe wie das Kontaktierungselement haben und auf der ersten Seite des Substrats angeordnet sein. Beispielweise kann das Fixierungselement großflächig zumindest teilweise auf den Bereichen der ersten Seite des Substrats aufgetragen sein, auf denen das Kontaktierungselement nicht aufgebracht ist. Alternativ oder zusätzlich können ein Fixierungselement oder mehrere Fixierungselemente punktförmig mit einem Abstand zwischen benachbarten Fixierungselementen auf der ersten Seite des Substrats angeordnet sein. Das Fixierungselement kann auch eine Folie oder ein Folienabschnitt sein, welcher beidseitig kleberbeschichtet ist.

Vorteilhaft können durch die mechanische Kontaktierung äußere mechanische Einwirkungen auf die zweite Seite des Substrats, beispielsweise durch Druck- oder Zugbelastungen, die beispielsweise beim Anbringen eines Bonddrahtes auf die zweite Seite des Substrats einwirken, besser verteilt werden, so dass die Verbindung zwischen dem Kontaktierungselement und der Kontaktoberfläche durch äußere mechanische Einwirkungen weniger belastet wird.

In einem weiteren Beispiel ist das Fixierungselement weiter angepasst, um das Substrat und das Elektronikbauteil gegeneinander elektrisch zu isolieren, und/oder
das Fixierungselement weist zumindest einen Kleber, eine Polymerfolie, insbesondere eine Polyimidfolie, ein Polymersubstrat, ein Keramiksubstrat, und/oder eine Sinterpaste oder Dickfilmpaste auf.

Vorteilhaft wird nicht der gesamte Bereich des Elektronikbauteils auf dem das Substrat angeordnet ist elektronisch kontaktiert, sondern nur das Kontaktierungselement mittels dem Kontaktbereich. Der Bereich des Elektronikbauteils, der von dem Fixierungselement kontaktiert wird, kann somit elektrisch isoliert werden. Weitere Bereiche des Elektronikbauteils, die von dem Adaptersystem überdeckt werden, können somit elektrisch isoliert werden.

In noch einem weiteren Beispiel entspricht die Ausdehnung des Kontaktierungselements auf der ersten Seite des Substrats im Wesentlichen der Ausdehnung der Kontaktoberfläche des Elektronikbauteils.

Vorteilhaft wird hierdurch die gesamte zur Verfügung stehende Kontaktoberfläche des Elektronikbauteils kontaktiert.

In einem Beispiel ist die Oberfläche der zweiten Seite des Substrats mindestens 20% größer als die Kontaktoberfläche des Elektronikbauteils, bevorzugt ist die Oberfläche der zweiten Seite zwischen 20% bis 1000%, bevorzugt 25% bis 500%, am bevorzugtesten 30% bis 200% größer als die Kontaktoberfläche des Elektronikbauteils.

Es hat sich überraschenderweise herausgestellt, dass ein optimales Verhältnis zwischen gesteigerter Stromtragfähigkeit des resultierenden Kontaktbereichs, sowie verbesserter Wärmeleitung und dem Mehrbedarf an Platz wegen der Kontaktbereichsvergrößerung erreicht wird, wenn die Oberfläche der zweiten Seite des Substrats mindestens 20% größer ist, als die Kontaktoberfläche des Elektronikbauteils.

In einem weiteren Beispiel ist die zweite Seite des Substrats zum Verbinden mit einem Verbindungselement, insbesondere mit einem Bonddraht, einem Bondbändchen, einem Clip, einem Presskontakt, einem Direct Copper Bonding, DCB, Substrat, einem Leadframe, einem Insulated Metal Substrat, IMS, einem Printed Circuit Board, PCB, und/oder mit einem Verbindungsstift angepasst, und/oder
die zweite Seite weist zumindest einen Bereich auf mit:
(i) zumindest einer Metallisierung, insbesondere mit einem Material das Nickel-Palladium-Gold, NiPdAu, Nickel-Gold, NiAu, und/oder Nickel-Silber, NiAg, umfasst,
(ii) zumindest einer Aussparung, und/oder
(iii) zumindest einer Erhebung.

Beispielsweise kann durch eine geeignete Metallisierung der zweiten Seite des Substrats, die Verwendung von Kupfer-Bonddrähten gewährleistet werden, die an der Kontaktoberfläche, die gewöhnlich aus Aluminium oder einer Aluminiumlegierung gefertigt sind, sonst nicht zuverlässig angebracht werden können. Alternativ oder zusätzlich können vorteilhaft Kontaktstrukturen auf der zweiten Seite des Substrats angeordnet sein, die wegen ihren Abmessungen nicht direkt auf der Kontaktoberfläche angeordnet werden können, die aber für eine elektrische Anbindung des Elektronikbauteils notwendig sind.

In einem weiteren Beispiel weist das Substrat ein elektrisch leitendes Metallelement auf, bevorzugt ein Kupfermaterial, eine Kupferlegierung, ein Aluminiummaterial, eine Aluminiumlegierung, und/oder ein Verbundmaterial, insbesondere ein Molybdän-Kupfer Verbundmaterial, ein Wolfram-Kupfer Verbundmaterial, ein Kupfer-Molybdän-Kupfer Verbundmaterial, und/oder ein Aluminium-Kupfer Verbundmaterial.

Vorteilhaft kann wegen dem elektrisch leitenden Metallelement ein elektrischer Kontakt zwischen der zweiten Seite des Substrats und der Kontaktoberfläche hergestellt werden.

In noch einem weiteren Beispiel weist das Kontaktierungselement zumindest eine Sinterpaste auf, bevorzugt eine Silber-Sinterpaste.

Vorteilhaft kann hierdurch das Kontaktierungselement auf die Kontaktoberfläche aufgesintert werden und somit eine zumindest elektrisch strapazierfähige Anbindung geschaffen werden.

In einem weiteren Beispiel weist das Elektronikbauteil mindestens zwei Kontaktoberflächen auf einer Seite des Elektronikbauteils auf, wobei die Kontaktoberflächen im Wesentlichen in einer Ebene liegen, und zumindest zwei Substrate zumindest bereichsweise auf dem Elektronikbauteil angeordnet sind, wobei zumindest eine Kontaktoberfläche mit einem Kontaktierungselement eines Substrats elektrisch verbunden ist, und/oder wobei mindestens zwei Kontaktoberflächen mit einem einzelnen Kontaktierungselement elektrisch verbunden sind.

Besonders vorteilhaft können Elektronikbauteile mit zwei oder mehreren Kontaktoberflächen auf einer Seite des Elektronikbauteils mit einem einzelnen Substrat zuverlässig und platzsparend kontaktiert werden. Beispielsweise können, wenn mindestens zwei Kontaktoberflächen mit einem einzelnen Kontaktierungselement elektrisch verbunden sind, Kontaktoberflächen mit gleicher Polung miteinander verbunden werden.

Alternativ oder ergänzend hierzu kann das Kontaktierungselement so ausgestaltet sein, dass es auf zwei oder mehreren Kontaktoberflächen angeordnet sein kann, beispielsweise aufgesintert sein kann, und diese Kontaktoberflächen miteinander verbindet. Vorteilhaft können somit bestimmte Anschlüsse von Transistoren, beispielsweise auf einem "Insulated-Gate Bipolar Transistor, IGBT, oder einem Metall-Oxid-Halbleiter-Feldeffekttransistor, MOSFET Chip", bereits auf der Oberfläche des Chips platzsparend und günstig miteinander verbunden werden, um die Transistoren miteinander zu verschalten, so dass eine separate Kontaktierung jeder einzelnen Kontaktoberfläche entfallen kann.

Die Erfindung schlägt auch ein Verfahren vor zur Kontaktbereichsvergrößerung zumindest einer Kontaktoberfläche auf zumindest einem Elektronikbauteil, aufweisend die Schritte:
Bereitstellen zumindest eines Substrats mit einer ersten Seite und einer der ersten Seite gegenüberliegenden zweiten Seite, wobei eine Oberfläche der zweiten Seite des Substrats größer ist als die Kontaktoberfläche des Elektronikbauteils;
Aufbringen zumindest eines Kontaktierungselements zumindest bereichsweise auf die erste Seite; und
Verbinden des Substrats mit dem Elektronikbauteil, wobei das Kontaktierungselement die erste Seite mit der Kontaktoberfläche des Elektronikbauteils elektrisch verbindet.

In einem Beispiel weist das Verfahren den Schritt auf:
Aufbringen zumindest eines Fixierungselements auf die erste Seite zumindest bereichsweise um das Kontaktierungselement herum, wobei das Fixierungselement angepasst ist das Elektronikbauteil zu kontaktieren, insbesondere die erste Seite mit dem Elektronikbauteil mechanisch zu verbinden.

In noch einem Beispiel weist das Verfahren den Schritt auf:
Aufbringen eines Verbindungselements, insbesondere einen Bonddraht, ein Bondbändchen, einen Clip, einen Presskontakt, ein Direct Copper Bonding, DCB, Substrat, ein Leadframe, ein Insulated Metal Substrat, IMS, ein Printed Circuit Board, PCB und/oder einen Verbindungsstift auf die zweite Seite des Substrats.

In noch einem weiteren Beispiel weist das Aufbringen des Kontaktierungselements weiter auf: Drucken, Dispensen, Jetten, Kleben und/oder Sprühen des Kontaktierungselements auf die erste Seite, und/oder Trocknen des Kontaktierungselements, und/oder Bereitstellen des Kontaktierungselements als Preform.

In einem Beispiel weist das Verbinden des Substrats mit dem Elektronikbauteil weiter auf: Platzieren des Kontaktierungselements auf der Kontaktoberfläche des Elektronikbauteils, Verbinden des Kontaktierungselements mit der Kontaktoberfläche des Elektronikbauteils mittels Wärme- und/oder Druckbeaufschlagung, insbesondere mittels Sintern, bevorzugt mittels Drucksintern, des Kontaktierungselements, und/oder
Aushärten des Fixierungselements, insbesondere Aushärten des Fixierungselements durch Wärme.

In einem weiteren Beispiel wird vor dem Verbinden des Substrats mit dem Elektronikbauteil:
(i) das Substrat mit der ersten Seite oder der zweiten Seite zum Transport auf ein Transportelement, insbesondere auf eine Klebefolie eines Film-Frames oder eines Wafer-Frames aufgebracht,
(ii) das Substrat auf dem Transportelement vereinzelt, und/oder
(iii) das Substrat mit dem Kontaktierungselement und dem Fixierungselement von dem Transportelement entfernt.

Die Erfindung schlägt auch ein Elektronikbauteil vor mit zumindest einem Adaptersystem zur Vergrößerung zumindest einer Kontaktoberfläche auf dem Elektronikbauteil.

Weitere Merkmale und Vorteile der Erfindung ergeben sich aus der nachfolgenden Beschreibung, in der bevorzugte Ausführungsformen der Erfindung anhand von schematischen Zeichnungen erläutert sind.

Dabei zeigt:

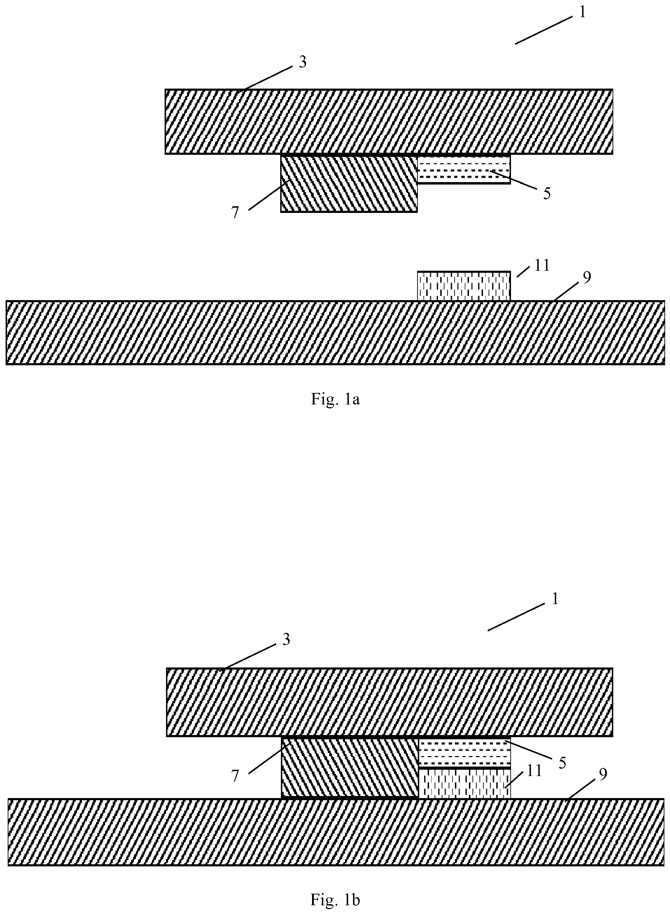

- Figur 1a: eine schematische Schnittansicht eines Adaptersystems gemäß einer ersten Ausführungsform der Erfindung, wobei das Kontaktierungselement von der Kontaktoberfläche beabstandet angeordnet gezeigt wird;
- Figur 1 b: eine schematische Schnittansicht eines Adaptersystems gemäß der ersten Ausführungsform der Erfindung, wobei das Kontaktierungselement angeordnet auf der Kontaktoberfläche gezeigt wird;
- Figur 2a, 2b: eine perspektivische Ansicht und eine Draufsicht eines Elektronikbauteils mit Kontaktoberflächen auf einer Seite des Elektronikbauteils gemäß einer zweiten Ausführungsform der Erfindung;
- Figur 3a, 3b: eine perspektivische Ansicht und eine Draufsicht eines Substrats mit einem Kontaktierungselement und einem Fixierungselement gemäß der zweiten Ausführungsform der Erfindung;
- Figur 4a, 4b: eine perspektivische Ansicht und eine Draufsicht eines Elektronikbauteils mit mehreren daran angeordneten Substraten gemäß der zweiten Ausführungsform der Erfindung;
- Figur 5a, 5b: eine perspektivische Ansicht und eine Draufsicht eines Elektronikbauteils mit einer Kontaktoberfläche auf einer Seite des Elektronikbauteils gemäß einer dritten Ausführungsform der Erfindung;
- Figur 6a, 6b: eine perspektivische Ansicht und eine Draufsicht eines Substrats mit einem Kontaktierungselement und einem Fixierungselement gemäß der dritten Ausführungsform der Erfindung; und
- Figur 7a, 7b: eine perspektivische Ansicht und eine Draufsicht eines Elektronikbauteils mit einem daran angeordneten Substrat gemäß der dritten Ausführungsform der Erfindung.

In Figur 1a wird eine schematische Schnittansicht eines Adaptersystems 1 gemäß einer ersten Ausführungsform der Erfindung gezeigt. In Figur 1a wird das Kontaktierungselement 5 von der Kontaktoberfläche 11 beabstandet angeordnet gezeigt.

In der dargestellten Ausführungsform ist die Kontaktoberfläche 11 als Kontakt auf dem Elektronikbauteil 9, insbesondere zur elektrischen Kontaktierung des Elektronikbauteils 9, angeordnet. Der Fachmann weiß, dass die Kontaktoberfläche 11 abhängig von dem verwendeten Elektronikbauteil 9 eine größere oder kleinere Fläche haben kann, die auf unterschiedlichen Bereichen des Elektronikbauteils 9 angeordnet sein kann und abhängig von der geplanten Anwendung eine unterschiedliche Geometrie haben kann. In Figur 1a wird die Kontaktoberfläche 11 als Erhebung, oder als ein auf dem Elektronikbauteil 9 angeordnetes Kontaktierungsmaterial dargestellt. In einer nicht gezeigten Ausführungsform kann die Kontaktoberfläche auch bündig mit der Oberfläche des Elektronikbauteils angeordnet sein, oder als Vertiefung in der Oberfläche des Elektronikbauteils angeordnet sein. Auch kann, in nicht gezeigten Ausführungsformen, der Kontakt kreisförmig, oval, rechteckig, vieleckig, oder durch eine Kombination aus den zuvor genannten Geometrien ausgebildet sein. In der gezeigten Ausführungsform kann das Elektronikbauteil 9 beispielsweise der Kontakt eines IGBT oder MOSFET Transistors sein und die Figuren 1a und 1b zeigen jeweils eine schematische Schnittansicht durch einen Bereich des IGBT oder MOSFET Transistors.

Die gezeigte Kontaktoberfläche 11 kann, wie es aus dem Stand der Technik bekannt ist, direkt kontaktiert werden, beispielsweise mittels eines Bonddrahtes. Eine solche Verbindung ist, wie es auch aus dem Stand der Technik bekannt ist, hohen thermo-mechanischen Belastungen ausgesetzt. Im Gegensatz zu den aus dem Stand der Technik bekannten Lösungen, wird in der gezeigten Ausführungsform ein Substrat 3, das elektrisch leitend ist, mit einem Kontaktierungselement 5 auf der Oberfläche des Elektronikbauteils 9 angeordnet. In der gezeigten Ausführungsform entspricht die Oberfläche des Kontaktierungselements 5 im Wesentlichen der Kontaktoberfläche 11, um somit möglichst die komplette zur Verfügung stehende Kontaktoberfläche 11 elektrisch zu kontaktieren.

Wie es weiterhin in Figur 1a gezeigt wird, kann zumindest ein Fixierungselement 7 auf der ersten Seite des Substrats 3 zumindest bereichsweise um das Kontaktierungselement 5 herum angeordnet sein. Der Fachmann weiß, dass das Fixierungselement 7 lediglich optional ist und für die Ausführbarkeit der Erfindung nicht essentiell ist. In Figur 1a wird das Fixierungselement 7 beispielhaft links neben dem Kontaktierungselement 5 und direkt an das Kontaktierungselement 5 angrenzend gezeigt. In nicht gezeigten Ausführungsformen kann das Fixierungselement 7 auch mit einem Abstand zu dem Kontaktierungselement 5 angeordnet sein, und/oder das Kontaktierungselement 5 vollständig umgebend angeordnet sein. In einer nicht gezeigten Ausführungsform kann das Kontaktierungselement 5 ein Klebstoff sein, der das Substrat 3 und das Elektronikbauteil 9 mechanisch verbindet und/oder gegeneinander isoliert. In einer weiteren nicht gezeigten Ausführungsform kann das Kontaktierungselement 7 aber auch eine Sinterpaste aufweisen, zum Aufsintern auf die Kontaktoberfläche 11.

In Figur 1b wird das in Figur 1a gezeigte Adaptersystem im montierten Zustand gezeigt. Das bedeutet, dass das Kontaktierungselement 5 auf der Kontaktoberfläche 11 angeordnet ist und mit dieser zumindest elektrisch verbunden ist. Das Fixierungselement 7 bewirkt eine mechanische Verbindung zwischen dem Substrat 3 und dem Elektronikbauteil 9. In einer nicht gezeigten Ausführungsform kann die zweite Seite des Substrats 3, die der ersten Seite mit dem Kontaktierungselement 5 gegenüberliegt, zumindest bereichsweise metallisiert sein, um eine verbesserte Kontaktierung mit zumindest einem Bonddraht zu gewährleisten. Alternativ oder zusätzlich hierzu, können auf der zweiten Seite auch Kontaktstrukturen angeordnet sein, die wegen ihren Abmessungen nicht direkt auf der Kontaktoberfläche 11 angeordnet werden können.

In Figur 1b wird auch gezeigt, dass die zweite Seite des Substrats 3 größer ist, als die Kontaktoberfläche 11 des Elektronikbauteils 9, um damit eine gesteigerte Stromtragfähigkeit, sowie eine verbesserte Wärmeleitung zu erreichen. In der gezeigten Ausführungsform sind die beiden Seiten des Substrats 3 gleich groß. In nicht gezeigten Ausführungsformen kann aber auch die erste Seite kleiner sein als die zweite Seite des Substrats, beispielsweise kann das Substrat einen konischen Querschnitt haben.

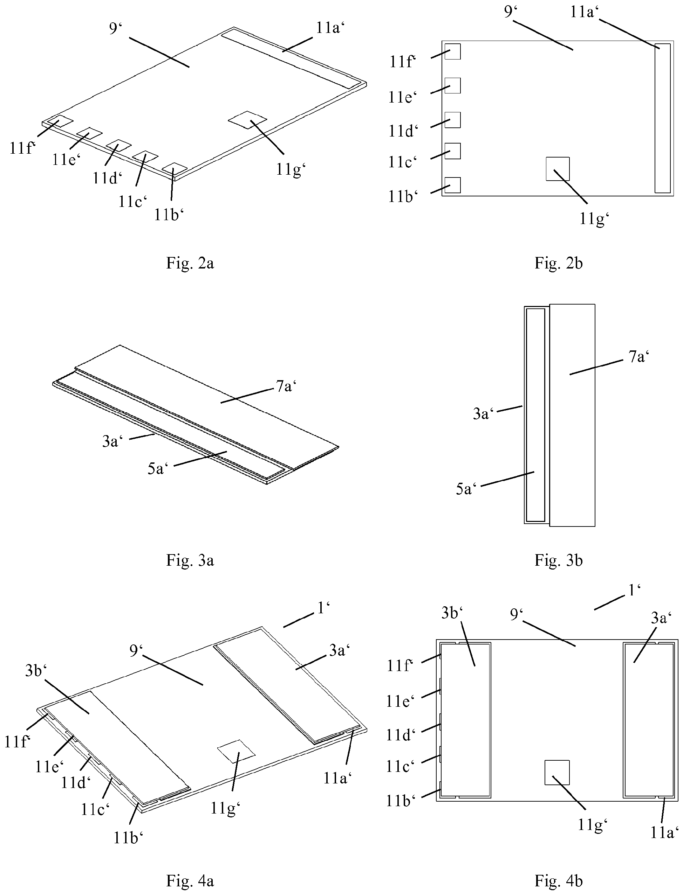

In den Figuren 2a und 2b wird eine perspektivische Ansicht und eine Draufsicht eines Elektronikbauteils 9' mit Kontaktoberflächen 11a' - 11g' auf einer Seite des Elektronikbauteils 9' gemäß einer zweiten Ausführungsform der Erfindung gezeigt. Im Wesentlichen kann das gezeigte Elektronikbauteil 9' ähnlich dem in den Figuren 1a und 1b gezeigten Elektronikbauteil 9 sein. Jedoch sind auf dem in den Figuren 2a und 2b gezeigten Elektronikbauteil 9' mehrere Kontaktoberflächen 11a' - 11g' auf einer Seite angeordnet. Die Dimensionen und Positionen der in den Figuren 2a und 2b gezeigten Kontaktoberflächen 11a' - 11g' sind lediglich beispielhaft. Der Fachmann weiß, dass diese Kontaktoberflächen 11a' - 11g' je nach Ausgestaltung des Elektronikbauteils 9' auf unterschiedlichen Positionen angeordnet sein können und unterschiedliche Abmessungen haben können.

In den Figuren 3a und 3b wird ein Substrat 3a' mit einem auf der ersten Seite angeordneten Kontaktierungselement 5a' und einem Fixierungselement 7a' gezeigt. Das Substrat 3a' kann beispielsweise das in Figur 1b gezeigte Substrat 3 mit dem dazugehörigen Kontaktierungselement 5 und dem Fixierungselement 7 sein. Eine Anordnung des in den Figuren 3a und 3b gezeigten Substrats 3a' auf dem Elektronikbauteil 9' wird in den Figuren 4a und 4b gezeigt. In den Figuren 4a und 4b wird außerdem ein zweites Substrat 3b' gezeigt, das gleich oder ähnlich aufgebaut sein kann wie das in den Figuren 3a und 3b gezeigte Substrat 3a', und das auf mehreren Kontaktoberflächen 11b' - 11f' angeordnet ist und mit diesen elektrisch verbunden ist. In einer nicht gezeigten Ausführungsform kann an dem Substrat für jede Kontaktoberfläche ein separates Kontaktierungselement angeordnet sein. Zwischen den Kontaktierungselementen kann in der nicht gezeigten Ausführungsform jeweils ein Fixierungselement angeordnet sein. Auch kann in der nicht gezeigten Ausführungsform ein Fixierungselement auf einer Kontaktoberfläche aus der Menge von mehreren Kontaktoberflächen angeordnet sein, so dass zwischen der jeweiligen Kontaktoberfläche und dem Substrat kein elektrischer Kontakt besteht.

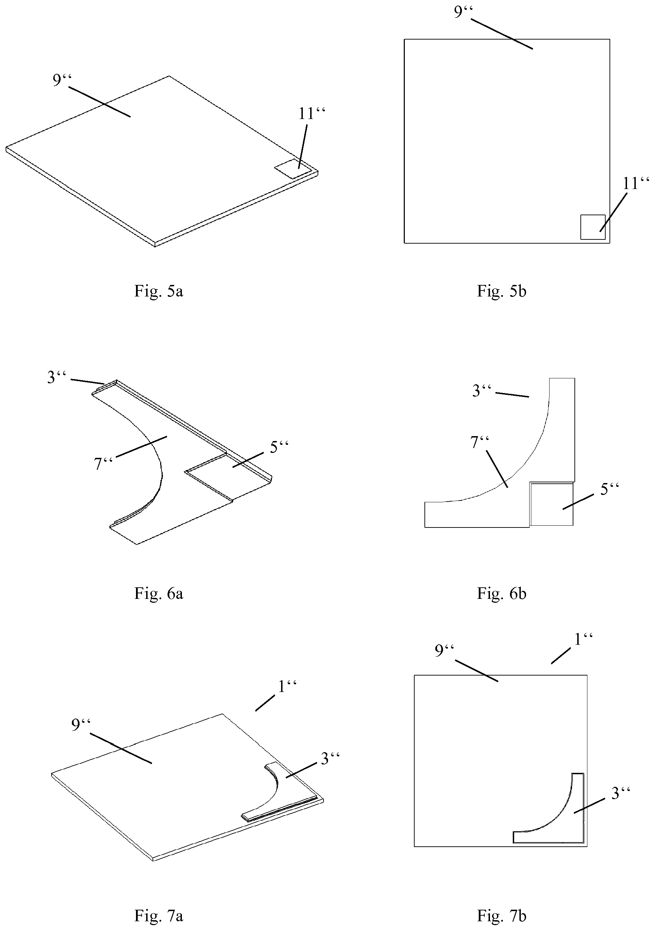

In den Figuren 5a und 5b wird eine perspektivische Ansicht eines Elektronikbauteils 9" mit einer Kontaktoberfläche 11" auf einer Seite des Elektronikbauteils 9" gemäß einer dritten Ausführungsform der Erfindung gezeigt. Im Wesentlichen kann das gezeigte Elektronikbauteil 9" einen ähnlichen Aufbau haben wie die in den Figuren zuvor gezeigten Elektronikbauteile 9, 9'. In der in den Figuren 5a und 5b gezeigten Ausführungsform befindet sich lediglich eine Kontaktoberfläche 11" an einem Eckbereich des Elektronikbauteils 9". Ein Substrat 3" gemäß der dritten Ausführungsform wird in den Figuren 6a und 6b gezeigt. Im Wesentlichen kann auch das gezeigte Substrat 3" den gleichen oder einen ähnlichen Aufbau haben wie die in den Figuren zuvor gezeigten Substrate 3, 3a', 3b'. Auf der ersten Seite des Substrats 3" ist, wie es in Figur 3b gezeigt wird, ein Kontaktierungselement 5" angeordnet, das im Wesentlichen die Fläche der Kontaktoberfläche 11" des Elektronikbauteils 9" hat. Angrenzend um das Kontaktierungselement 5" herum, bzw. an mindestens zwei Seiten des Kontaktierungselements 5", ist ein Fixierungselement 7" zur mechanischen Kontaktierung des Elektronikbauteils 9" angeordnet.

Eine Anordnung des in den Figuren 6a und 6b gezeigten Substrats 3" auf dem Elektronikbauteil 9" wird in den Figuren 7a und 7b gezeigt.

Weitere Merkmale und Vorteile der Erfindung ergeben sich aus der nachfolgenden Beschreibung, in der bevorzugte Ausführungsformen der Erfindung anhand von schematischen Zeichnungen erläutert sind.

### Bezugszeichenliste

- 1, 1', 1": Adaptersystem
- 3, 3a', 3b', 3": Substrat
- 5, 5a', 5": Kontaktierungselement
- 7, 7a', 7": Fixierungselement
- 9, 9', 9": Elektronikbauteil
- 11, 11a'- 11f', 11": Kontaktoberfläche

## Patentansprüche

1. Adaptersystem zur Kontaktbereichsvergrößerung zumindest einer Kontaktoberfläche (11, 11a', 11b', 11c', 11d', 11e', 11 ") auf zumindest einem Elektronikbauteil (9, 9', 9"), aufweisend:
zumindest ein Substrat (3, 3a', 3b', 3") mit einer ersten Seite und einer der ersten Seite gegenüberliegenden zweiten Seite;
zumindest ein Kontaktierungselement (5, 5a', 5"), das zumindest bereichsweise auf der ersten Seite des Substrats (3, 3a', 3b', 3") angeordnet ist, wobei das Kontaktierungselement (5, 5a', 5") angepasst ist die erste Seite mit der Kontaktoberfläche (11, 11a', 11b', 11 c', 11d', 11 e', 11 ") des Elektronikbauteils (9, 9', 9") elektrisch zu verbinden, wobei eine Oberfläche der zweiten Seite des Substrats (3, 3a', 3b', 3") größer ist als die Kontaktoberfläche (11, 11a', 11b', 11c', 11d', 11e', 11 ") des Elektronikbauteils (9, 9', 9").

2. Adaptersystem nach Anspruch 1, weiter aufweisend:
zumindest ein Fixierungselement (7, 7a', 7"), das auf der ersten Seite des Substrats (3, 3a', 3b', 3") zumindest bereichsweise um das Kontaktierungselement (5, 5a', 5") herum angeordnet ist, wobei das Fixierungselement (7, 7a', 7") angepasst ist das Elektronikbauteil (9, 9', 9") mechanisch zu kontaktieren, insbesondere die erste Seite des Substrats (3, 3a', 3b', 3") mit dem Elektronikbauteil (9, 9', 9") mechanisch zu verbinden.

3. Adaptersystem nach Anspruch 2, **dadurch gekennzeichnet, dass** das Fixierungselement (7, 7a', 7") weiter angepasst ist das Substrat (3, 3a', 3b', 3") und das Elektronikbauteil (9, 9', 9") gegeneinander elektrisch zu isolieren, und/oder
das Fixierungselement (7, 7a', 7") weist zumindest einen Kleber, eine Polymerfolie, insbesondere eine Polyimidfolie, ein Polymersubstrat, ein Keramiksubstrat, und/oder eine Sinterpaste oder Dickfilmpaste auf.

4. Adaptersystem nach einem der vorangehenden Ansprüche, **dadurch gekennzeichnet, dass** die Ausdehnung des Kontaktierungselements (5, 5a', 5") auf der ersten Seite des Substrats (3, 3a', 3b', 3") im Wesentlichen der Ausdehnung der Kontaktoberfläche (11, 11a', 11b', 11c', 11d', 11e', 11") des Elektronikbauteils (9, 9', 9") entspricht.

5. Adaptersystem nach einem der vorangehenden Ansprüche, **dadurch gekennzeichnet, dass** die Oberfläche der zweiten Seite des Substrats (3, 3a', 3b', 3") mindestens 20% größer ist als die Kontaktoberfläche (11, 11a', 11b', 11c', 11d', 11e', 11") des Elektronikbauteils (9, 9', 9"), bevorzugt ist die Oberfläche der zweiten Seite zwischen 20% bis 1000%, bevorzugt 25% bis 500%, am bevorzugtesten 30% bis 200% größer als die Kontaktoberfläche (11, 11a', 11b', 11c', 11d', 11e', 11 ") des Elektronikbauteils (9, 9', 9").

6. Adaptersystem nach einem der vorangehenden Ansprüche, **dadurch gekennzeichnet, dass** die zweite Seite des Substrats (3, 3a', 3b', 3") zum Verbinden mit einem Verbindungselement, insbesondere mit einem Bonddraht, einem Bondbändchen, einem Clip, einem Presskontakt, einem Direct Copper Bonding, DCB, Substrat, einem Leadframe, einem Insulated Metal Substrat, IMS, einem Printed Circuit Board, PCB, und/oder mit einem Verbindungsstift angepasst ist, und/oder wobei die zweite Seite zumindest einen Bereich aufweist mit:
(i) zumindest einer Metallisierung, insbesondere mit einem Material das Nickel-Palladium-Gold, NiPdAu, Nickel-Gold, NiAu, und/oder Nickel-Silber, NiAg, umfasst,
(ii) zumindest einer Aussparung, und/oder
(iii) zumindest einer Erhebung.

7. Adaptersystem nach einem der vorangehenden Ansprüche, **dadurch gekennzeichnet, dass** das Substrat (3, 3a', 3b', 3") ein elektrisch leitendes Metallelement aufweist, bevorzugt ein Kupfermaterial, eine Kupferlegierung, ein Aluminiummaterial, eine Aluminiumlegierung, und/oder ein Verbundmaterial, insbesondere ein Molybdän-Kupfer Verbundmaterial, ein Wolfram-Kupfer Verbundmaterial, ein Kupfer-Molybdän-Kupfer Verbundmaterial, und/oder ein Aluminium-Kupfer Verbundmaterial.

8. Adaptersystem nach einem der vorangehenden Ansprüche, **dadurch gekennzeichnet, dass** das Kontaktierungselement (5, 5a', 5") zumindest eine Sinterpaste aufweist, bevorzugt eine Silber-Sinterpaste.

9. Adaptersystem nach einem der vorangehenden Ansprüche, **dadurch gekennzeichnet, dass**
das Elektronikbauteil (9') mindestens zwei Kontaktoberflächen (11a', 11b', 11c', 11d', 11e') auf einer Seite des Elektronikbauteils (9') aufweist,
wobei die Kontaktoberflächen (11a', 11b', 11c', 11d', 11e') im Wesentlichen in einer Ebene liegen, und zumindest zwei Substrate (3a', 3b') zumindest bereichsweise auf dem Elektronikbauteil (9') angeordnet sind, wobei zumindest eine Kontaktoberfläche (11a', 11b', 11c', 11 d', 11e') mit einem Kontaktierungselement (5a') eines Substrats (3a', 3b') elektrisch verbunden ist, und/oder
wobei mindestens zwei Kontaktoberflächen (11b', 11c', 11d') mit einem einzelnen Kontaktierungselement (5a') elektrisch verbunden sind.

10. Verfahren zur Kontaktbereichsvergrößerung zumindest einer Kontaktoberfläche (11, 11a', 11b', 11c', 11d', 11e', 11 ") auf zumindest einem Elektronikbauteil (9, 9', 9"), aufweisend die Schritte:
Bereitstellen zumindest eines Substrats (3, 3a', 3b', 3") mit einer ersten Seite und einer der ersten Seite gegenüberliegenden zweiten Seite, wobei eine Oberfläche der zweiten Seite des Substrats (3, 3a', 3b', 3") größer ist als die Kontaktoberfläche (11, 11a', 11b', 11c', 11d', 11e', 11 ") des Elektronikbauteils (9, 9', 9");
Aufbringen zumindest eines Kontaktierungselements (5, 5a', 5") zumindest bereichsweise auf die erste Seite; und
Verbinden des Substrats (3, 3a', 3b', 3") mit dem Elektronikbauteil (9, 9', 9"), wobei das Kontaktierungselement (5, 5a', 5") die erste Seite mit der Kontaktoberfläche (11, 11a', 11b', 11c', 11d', 11e', 11") des Elektronikbauteils (9, 9', 9") elektrisch verbindet.

11. Das Verfahren nach Anspruch 10, weiter aufweisend den Schritt:
Aufbringen zumindest eines Fixierungselements (7, 7a', 7") auf die erste Seite zumindest bereichsweise um das Kontaktierungselement (5, 5a', 5") herum, wobei das Fixierungselement (7, 7a', 7") angepasst ist das Elektronikbauteil (9, 9', 9") zu kontaktieren, insbesondere die erste Seite mit dem Elektronikbauteil (9, 9', 9") mechanisch zu verbinden.

12. Das Verfahren nach Anspruch 10 oder 11, weiter aufweisend den Schritt:
Aufbringen eines Verbindungselements, insbesondere einen Bonddraht, ein Bondbändchen, einen Clip, einen Presskontakt, ein Direct Copper Bonding, DCB, Substrat, ein Leadframe, ein Insulated Metal Substrat, IMS, ein Printed Circuit Board, PCB, und/oder einen Verbindungsstift auf die zweite Seite des Substrats (3, 3a', 3b', 3").

13. Das Verfahren nach einem der Ansprüche 10 bis 12, **dadurch gekennzeichnet, dass** das Verbinden des Substrats (3, 3a', 3b', 3") mit dem Elektronikbauteil (9, 9', 9") weiter aufweist:
Platzieren des Kontaktierungselements (5, 5a', 5") auf der Kontaktoberfläche (11, 11a', 11b', 11c', 11d', 11e', 11") des Elektronikbauteils (9, 9', 9"),
Verbinden des Kontaktierungselements (5, 5a', 5") mit der Kontaktoberfläche (11, 11a', 11b', 11c', 11d', 11e', 11 ") des Elektronikbauteils (9, 9', 9") mittels Wärme- und/oder Druckbeaufschlagung, insbesondere mittels Sintern, bevorzugt mittels Drucksintern, des Kontaktierungselements (5, 5a', 5"), und/oder
Aushärten des Fixierungselements (7, 7a', 7"), insbesondere Aushärten des Fixierungselements (7, 7a', 7") durch Wärme.

14. Das Verfahren nach einem der Ansprüche 10 bis 13, **dadurch gekennzeichnet, dass** vor dem Verbinden des Substrats (3, 3a', 3b', 3") mit dem Elektronikbauteil (9, 9', 9"):
(i) das Substrat (3, 3a', 3b', 3") mit der ersten Seite oder der zweiten Seite zum Transport auf ein Transportelement, insbesondere auf eine Klebefolie eines Film-Frames oder eines Wafer-Frames aufgebracht wird,
(ii) das Substrat (3, 3a', 3b', 3") auf dem Transportelement vereinzelt wird, und/oder
(iii) das Substrat (3, 3a', 3b', 3") mit dem Kontaktierungselement (5, 5a', 5") und dem Fixierungselement (7, 7a', 7") von dem Transportelement entfernt wird.

15. Elektronikbauteil mit zumindest einem Adaptersystem nach einem der Ansprüche 1 bis 9 zur Vergrößerung zumindest einer Kontaktoberfläche auf dem Elektronikbauteil.
